# FASCICULE DE BREVET EUROPEEN

(11) **EP 2 463 632 B1**
(45) Date de publication et mention de la délivrance du brevet: **05.06.2013**
(21) Numéro de dépôt: 11354072.8
(22) Date de dépôt: 01.12.2011
(51) Int. Cl.: G01J 1/02, G01R 31/26, G01R 35/00, G01J 1/44

(54) **Dispositif de détection comportant un circuit de test robuste**
Erfassungsvorrichtung, die einen robusten Testkreislauf umfasst
Detection device comprising a robust test circuit

(30) Priorité: 07.12.2010 FR 1004761
(43) Date de publication de la demande: 13.06.2012
(73) Titulaire: Société Française de Détecteurs Infrarouges - SOFRADIR, 92290 Châtenay Malabry (FR)
(72) Inventeur: Lefoul, Xavier, 38000 Grenoble (FR)
(74) Mandataire: Talbot, Alexandre

(56) Documents cités:
- US-A1- 2010 283 474

## Description

### Domaine technique de l'invention

L'invention est relative à un dispositif de détection comportant un photodétecteur muni de première et seconde bornes, un circuit de lecture muni d'une entrée reliée à la première borne du photodétecteur, un circuit de polarisation imposant une polarisation aux bornes du photodétecteur.

### État de la technique

De manière classique, un dispositif de détection comporte un photodétecteur et un circuit de lecture. Le photodétecteur est soumis à un régime de polarisation particulier de manière à délivrer un courant représentatif de la scène observée.

Le courant provenant du photodétecteur est acheminé au circuit de lecture qui réalise le traitement de l'information.

Pour s'assurer que le résultat obtenu soit représentatif de la scène observée, il faut être en mesure de décorréler le fonctionnement du photodétecteur de celui du circuit de lecture afin de déterminer quel élément est défectueux.

Pour confirmer que le circuit de lecture est fonctionnel ou défectueux, ce dernier est testé indépendamment du photodétecteur. Ainsi, lors d'une défaillance, il est possible de déterminer si cette dernière provient de la partie comportant le photodétecteur ou de la partie comportant le circuit de lecture. Afin de conserver une densité d'intégration importante et une facilité d'utilisation, il est intéressant d'intégrer ce circuit de test au plus près du dispositif de détection.

Un exemple de dispositif connu est décrit dans le document US 2010 0283474.

### Objet de l'invention

On constate qu'il existe un besoin de prévoir un dispositif de détection qui soit simple, compact et robuste tout en permettant la détection d'un disfonctionnement entre le photodétecteur et le circuit de lecture.

On tend à satisfaire ce besoin au moyen d'un dispositif de détection selon les revendications annexées et plus particulièrement au moyen d'un dispositif qui comporte un circuit de test délivrant un courant de test au photodétecteur, le circuit de test comprenant un premier transistor traversé par le courant de test, le premier transistor présente une première électrode principale reliée à l'entrée du circuit de lecture et configurée de manière à avoir une diode de jonction s'opposant au passage des porteurs de charge lorsque le potentiel présent à la borne commune entre le circuit de lecture et le circuit de test atteint une valeur seuil.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un dispositif de détection,
- la figure 2 représente, de manière schématique, un mode de réalisation particulier d'un dispositif de détection,
- la figure 3 représente, de manière schématique, un autre mode de réalisation particulier d'un dispositif de détection,.

### Description d'un mode préférentiel de l'invention

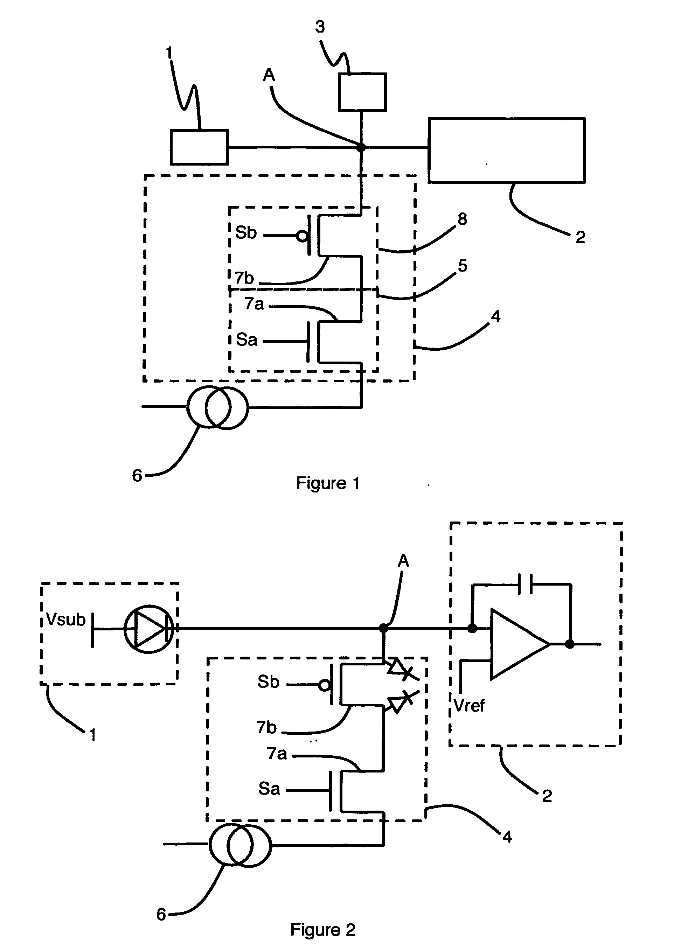

Comme cela est illustré à la figure 1, le dispositif de détection comporte un photodétecteur 1 avec des première et seconde bornes. La première borne du photodétecteur est reliée à une entrée d'un circuit de lecture 2. Le circuit de lecture 2 reçoit le signal provenant du photodétecteur 1 et le traite.

Le photodétecteur 1 est soumis à une polarisation spécifique afin de le faire fonctionner dans la gamme recherchée. La polarisation aux bornes du photodétecteur est obtenue au moyen d'un circuit de polarisation 3. De manière générale, le photodétecteur 1 est un élément de détection sur lequel est appliquée une différence de potentiel à ses bornes.

Le photodétecteur 1 délivre un courant représentatif de l'illumination de la scène observée. Le photodétecteur 1 est, de préférence, une photodiode qui est polarisée en inverse afin de fournir un courant représentatif de la scène observée. La photodiode 1 est avantageusement réalisée par une diode de type N/P, P/N N/I/P ou P/I/N. Cependant, selon le type de photodétecteur utilisé, la polarisation imposée change.

A titre d'exemple, si le substrat est de type P, la photodiode est formée par une partie du substrat semi-conducteur et par une zone dopée de type N formée dans ce substrat. Au contraire, si le substrat est de type N, la photodiode est formée par une partie du substrat semi-conducteur et par une zone dopée de type P formée dans ce substrat.

Dans certains modes de réalisation, il est nécessaire d'imposer une polarisation importante pour assurer le fonctionnement correct du photodétecteur ou de l'ensemble des photodétecteurs 1 organisés en matrice. A titre d'exemple, le photodétecteur est une photodiode à avalanche ou un dispositif à puits quantiques qui nécessite l'application d'une polarisation « inverse » de grande amplitude. La polarisation importante est avantageusement appliquée par l'intermédiaire du substrat. Quel que soit le mode de réalisation, l'anode du photodétecteur 1 est l'électrode présentant le potentiel le plus bas et la cathode est l'électrode présentant le potentiel le plus haut. Selon le potentiel appliqué, le sens du courant de porteurs change.

Le circuit de lecture 2 peut être de type amplificateur capacitif transimpédance (CTIA) ou de type circuit à injection directe contre-réactionnée (BDI). Le circuit de lecture 2 réalise l'acquisition du signal émis par le photodétecteur et son traitement. Le circuit de lecture 2 possède une fonction transimpédance qui transforme le signal en courant émis par le photodétecteur 1 en un signal en tension. De manière avantageuse, le signal en courant est intégré sur une certaine période de temps pour définir le signal en tension. De manière également avantageuse, le circuit de lecture 2 comporte un condensateur qui réalise l'intégration du courant délivré par le photodétecteur 1.

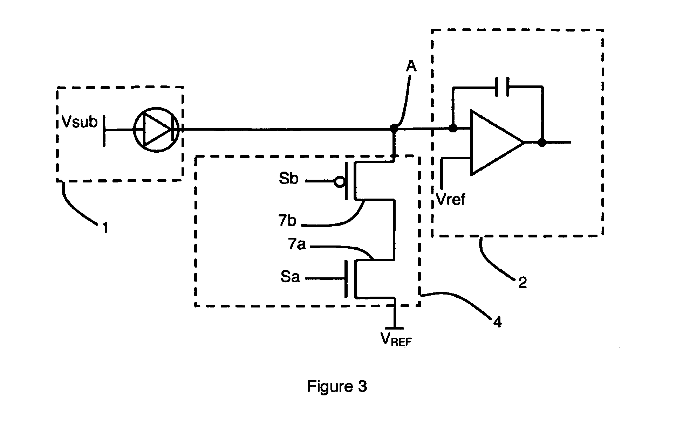

Le circuit de polarisation 3 réalise la polarisation du photodétecteur 1 dans les conditions recherchées. Dans certains modes de réalisation, le circuit de polarisation 3 est intégré dans le circuit de lecture 2. Le circuit de lecture 2 assure alors simultanément la polarisation du photodétecteur 1, l'acquisition et le traitement de l'information provenant du photodétecteur 1. Dans le mode de réalisation de la figure 1, le circuit de polarisation 3 est connecté au noeud commun entre le circuit de lecture 2 et le photodétecteur. Dans le mode de réalisation illustré aux figures 2 et 3, la polarisation du photodétecteur 1 est réalisée au moyen du circuit de lecture 2.

Le dispositif comporte également un circuit de test 4 qui simule le fonctionnement du photodétecteur 1. Dans ce but, le circuit de test 4 délivre un courant de test au circuit de lecture 2.

De cette manière, il est possible de contrôler indépendamment le fonctionnement du circuit de lecture 2 et le fonctionnement du photodétecteur 1. De manière avantageuse, le circuit de test 4 est disposé au plus près du circuit de lecture 2 afin d'éviter les signaux parasites et/ou distordus et contrôler au mieux le fonctionnement du circuit de lecture 2. Afin d'obtenir un dispositif compact, le circuit de test 4 est de taille réduite et comporte peu d'éléments actifs.

Le circuit de test 4 et le photodétecteur 1 sont reliés tous les deux à une même entrée du circuit de lecture 2 ce qui forme un noeud électrique A. Entre le noeud A et le circuit de lecture 2, le courant délivré par le circuit de test 4 est dans le même sens que le courant provenant du photodétecteur 1. Le circuit de test 4 envoie, dans le circuit de lecture 2, un courant de test représentatif d'un signal à traiter.

Le circuit de test 4 envoie un signal en courant au circuit de lecture 2 afin de simuler le fonctionnement du photodétecteur 1. Le circuit de test 4 comporte un moyen de modulation 5 du courant envoyé au module de lecture 2. Bien que le sens de déplacement des porteurs de charge change selon la polarisation appliquée, il est considéré que le circuit de test 4 et le photodétecteur 1 génèrent un courant. Selon les cas, le courant transitant du photodétecteur 1 au circuit de lecture est un courant de trous d'électrons ou un courant d'électrons.

Dans un mode de réalisation particulier, le circuit de test 4 comporte une source de courant 6 qui est avantageusement reliée au circuit de lecture 2 par l'intermédiaire du moyen de modulation 5 du passage de courant. Le moyen de modulation 5 du courant comporte au moins un premier transistor 7a. Le circuit de test 4 comporte également un moyen de protection 8 avec un second transistor 7b. Le second transistor 7b est connecté entre le moyen de modulation et le noeud A. Les deux transistors 7a, 7b sont traversés par le courant de test. Les deux transistors 7a, 7b sont de types opposés et montés en série. Plus de deux transistors peuvent néanmoins être intégrés dans le circuit de test 4.

Selon le nombre de transistors intégrés dans le circuit 4, ce dernier reçoit au moins deux signaux de commande Sa, Sb qui réalisent la commande des différents transistors 7a, 7b. Ainsi, selon les signaux imposés, les transistors 7 sont dans un état passant ou bloqué.

Dans un mode de réalisation illustré à la figure 2, la source de courant 6 envoie un signal représentatif du fonctionnement du photodétecteur. Le moyen de modulation 5 et le moyen de protection 8 autorisent ou bloquent le passage du courant entre la source de courant 6 et le circuit de lecture 2. Les signaux Sa et Sb sont donc de type numérique en basculant les transistors 7a et 7b entre des états bloqués et passants. La modulation fine de la valeur du courant est réalisée par la source 6. Selon les modes de réalisation, la source de courant 6 peut être intégrée au module qui comprend le circuit de détection ou être un élément extérieur à ce module.

Dans un autre mode de réalisation illustré à la figure 3, un potentiel de test V_{TEST} est appliqué à une borne d'entrée du circuit de test 4. Une borne de sortie du circuit de test 4 est connectée à l'entrée du circuit de lecture 2 par le noeud A. Le moyen de modulation 5 permet de moduler l'intensité du courant qui circule depuis le potentiel appliqué sur la borne d'entrée vers le circuit de lecture 2 de manière à simuler le fonctionnement du photodétecteur 1. La source de courant fait alors partie du circuit de test 4 par l'intermédiaire du moyen de modulation. Le potentiel V_{TEST} appliqué sur la borne d'entrée est choisi de manière à obtenir le même sens de transit des porteurs que le photodétecteur 1. La différence de potentiel qui existe entre le noeud A et le potentiel V_{SUB} est de même signe que la différence de potentiel qui existe entre le noeud A et le potentiel V_{TEST}. Le signal de commande appliqué sur le moyen de modulation 5 permet de faire évoluer la quantité de courant pouvant traverser. Cela permet alors de simuler le fonctionnement du photodétecteur 1. Comme dans le mode précédent, le moyen de modulation 5 comporte au moins un transistor 7a.

Dans une variante de réalisation, le transistor 7b du moyen de protection est également utilisé pour réaliser la modulation du courant fourni par les moyens de modulation 5.

Un ou plusieurs signaux Sa et Sb sont appliqués pour réaliser la modulation de la valeur du courant. Le signal Sb est de type analogique alors que le signal Sa peut être de type numérique ou analogique.

Si le photodétecteur 1 présente un disfonctionnement qui se traduit par un court-circuit, le potentiel appliqué sur le substrat V_{SUB} se retrouve également appliqué au noeud électrique A. Il y a donc une possibilité que le potentiel du substrat ou un potentiel proche de V_{SUB} soit appliqué à l'entrée du circuit de lecture 2 et sur le circuit de test 4. La polarisation du photodétecteur 1 se répercute alors sur les divers circuits du dispositif. Il en va de même si le circuit de lecture impose un potentiel au noeud électrique A qui entraîne le passage en polarisation directe du photodétecteur 1. A titre d'exemple, le potentiel peut évoluer si la quantité de charges emmagasinée dans le condensateur du circuit de lecture est très importante et s'il ne comporte pas de dispositif d'anti-éblouissement ou si ce dernier est défectueux.

Lorsque le photodétecteur 1 est en court-circuit, le potentiel du substrat V_{SUB} se répercute sur le noeud électrique A et donc sur la sortie du circuit de test 4. Il en ressort que ce potentiel est appliqué sur une des électrodes de source/drain du second transistor 7b du moyen de protection 8.

Il en va de même si le circuit de lecture 2 impose un potentiel décalé au noeud A qui passe par exemple le photodétecteur 1 en polarisation directe, par exemple à cause d'un flux de courant trop important imposé par le photodétecteur stocké dans un condensateur d'intégration.

Si le photodétecteur peut être assimilé à une photodiode polarisée en inverse, un potentiel plus faible est imposé sur l'anode comparé au potentiel imposé sur la cathode. Dans le cas d'une jonction de type P/N ou N/P cela se traduit par le fait que la zone dopée P est à un potentiel plus faible que la zone dopée N.

Dans les transistors 7, il y a au moins une zone dopée de type P et une zone dopée de type N. Le transistor 7 comporte une première électrode principale, une seconde électrode principale et une électrode de commande. Les première et seconde électrodes principales sont formées par des zones du même type de dopage qui sont séparées par une zone de dopage opposée. Il y a donc dans le transistor 7 deux diodes de jonction formées par la connexion entre deux zones avec des dopages différents. Chaque électrode principale est associée à une diode de jonction. Les diodes de jonction sont représentées à titre d'illustration sur le transistor 7b de la figure 2.

Lorsque le potentiel de substrat V_{SUB} se trouve appliqué au noeud A, ce même potentiel de substrat est appliqué à l'entrée du second transistor 7b adjacent, appelée ici première électrode principale. Pour éviter que la diode de jonction de la première électrode principale ne soit passante, c'est-à-dire qu'un potentiel plus faible soit appliqué à la zone dopée de type N par rapport à la zone dopée de type P, le type du second transistor 7b est choisi en conséquence. Le second transistor 7b présente alors des électrodes principales dont le type de conductivité est opposé à celui de l'électrode connectée au circuit de lecture 2. Ainsi, la diode du photodétecteur et la diode de jonction à l'entrée du second transistor 7b sont montées dans le même sens. De manière générale, le type du second transistor est choisi de manière à ce que la diode de jonction empêche le passage du courant lorsque le photodétecteur 1 est en court-circuit, c'est-à-dire lorsque le potentiel de substrat V_{SUB} se retrouve présent au noeud A. Un raisonnement identique peut être appliqué lorsque le potentiel du noeud A est décalé du fait du circuit de lecture 2. De manière générale, le second transistor est configuré de manière à avoir une diode de jonction s'opposant au passage des porteurs de charge lorsque le potentiel présent à la borne commune entre le circuit de lecture 2 et le circuit de test 4 atteint une valeur seuil, ici une valeur minimale sur les figures 2 et 3.

Dans un mode de réalisation particulier, la cathode (zone dopée de type N d'une diode) du photodétecteur 1 est connectée au module de lecture 2. Le second transistor 7b est de type pMOS, il a donc une électrode principale dopée de type P reliée au noeud A. La diode de jonction est formée par l'électrode principale et le substrat. La diode de jonction est montée dans le même sens que la diode équivalente du photodétecteur lorsque les électrons transitent depuis le photodétecteur 1 vers le substrat contenant le second transistor 7b. Le circuit de test 4 comporte deux transistors 7a et 7b de types opposés et montés en série, le type du second transistor 7b est fixé par la différence de potentiel qui existe aux bornes du photodétecteur. Dans un mode de réalisation avantageux car compact, le circuit de test est constitué par les transistors 7a et 7b. Le circuit de test peut alors être associé à une source de courant ou à une source de tension.

Comme cela est illustré à la figure 1, un transistor 7b de type pMOS est monté en série avec un transistor 7a de type nMOS entre la source de courant 6 et le noeud électrique A, c'est-à-dire entre la source de courant 6 et l'entrée du circuit de lecture 2. Le premier transistor 7a est séparé du circuit de lecture 2 par le second transistor 7b.

Sur la figure 2, le transistor 7b connecté au noeud A est de type pMOS. Si les porteurs se déplacent schématiquement depuis le potentiel de substrat V_{SUB} vers le circuit de test 4, ils traversent une première jonction de type P/N dans le photodétecteur 1 et arrivent à une seconde jonction de type P/N dans le transistor 7b. Dans ce cas de figure, le potentiel de substrat V_{SUB} appliqué à la zone dopée de type P du transistor 7b polarise cette électrode en inverse. Aucun courant ne passe car la diode de jonction de la première électrode principale du transistor 7b reliée au noeud A est polarisée de manière à être bloquée.

Si le jeu de polarisation est inversé, le circuit de lecture est relié à l'anode du photodétecteur et le transistor du moyen de protection est de type nMOS, c'est-à-dire que le second transistor 7b est de type nMOS.

La diode de jonction du transistor 7b est choisie de manière à être dans le même sens que la diode équivalente du photodétecteur. Cette particularité architecturale permet d'éviter la présence d'un courant parasite à partir du circuit de test lors d'une éventuelle défaillance du photodétecteur par court-circuit.

Le transistor 7b connecté au noeud A est choisi de manière à éviter l'apparition d'un courant parasite si le photodétecteur entre en court-circuit. Le transistor 7a de type opposé permet une plus grande liberté de polarisation pour définir la quantité de courant pouvant passer vers le circuit de lecture 2 lors des phases de test. Il évite également que l'électrode de drain du second transistor 7b ne soit directement reliée à la source de courant ou de tension

Cette architecture reste simple et compacte car elle est essentiellement formée par deux transistors montés en série ce qui permet de l'intégrer au plus près du circuit de lecture 2.

Dans le cas particulier illustré à la figure 2 où le circuit de lecture est de type amplificateur capacitif transimpédance, la polarisation du photodétecteur est réalisée entre le potentiel substrat V_{SUB} imposé sur le substrat et le potentiel de référence V_{REF} imposé par le circuit de lecture 2. Le circuit de polarisation 3 est intégré dans le circuit de lecture 2.

Dans un fonctionnement normal, le potentiel de référence V_{REF} est présent au noeud A. En cas de court-circuit du photodétecteur 1, le potentiel de substrat V_{SUB} est présent au noeud A et le type du transistor 7b est choisi de manière à ce que l'application du potentiel V_{SUB} sur la première borne principale rende la diode de jonction bloquée.

La polarisation des transistors 7 est réalisée de manière conventionnelle. Dans le cas d'un transistor pMOS, le potentiel appliqué sur le caisson contenant le canal est plus positif que le potentiel appliqué sur les électrodes de source et drain. Dans le cas d'un transistor nMOS, le potentiel appliqué sur le caisson contenant le canal est plus négatif que le potentiel appliqué sur les électrodes de source et drain. De cette manière, les diodes de jonction des électrodes de source et de drain sont toujours bloquées vis-à-vis du caisson sans pour autant gêner le fonctionnement du transistor au niveau du canal.

## Revendications

1. Dispositif de détection comportant :
- un photodétecteur (1) muni de première et seconde bornes,
- un circuit de lecture (2) muni d'une entrée reliée à la première borne du photodétecteur (1),
- un circuit de polarisation (3) imposant une polarisation aux bornes du photodétecteur (1),
- un circuit de test (4) délivrant un courant de test au circuit de lecture (2), dispositif **caractérisé en ce que** le circuit de test (4) comprend un premier transistor (7a) et un second transistor (7b) de types opposés connectés en série et traversés par le courant de test, le premier transistor (7) est séparé du circuit de lecture (2) par le second transistor (7b) muni d'une première électrode principale reliée à l'entrée du circuit de lecture (2) et configurée de manière à avoir une diode de jonction s'opposant au passage des porteurs de charge lorsque le potentiel présent sur la deuxième borne du photodétecteur (1) est présent sur la première borne du photodétecteur (1).

2. Dispositif selon la revendication 1, dans lequel la cathode du photodétecteur (1) est connectée au circuit de lecture (2), le premier transistor (7a) est de type nMOS et le second transistor (7b) est de type pMOS ou dans lequel l'anode du photodétecteur (1) est connectée au circuit de lecture (2), le premier transistor (7a) est de type pMOS et le second transistor (7b) est de type nMOS.

3. Dispositif selon l'une des revendications 1 à 2, dans lequel le circuit de test (2) comporte une source de courant (6).

4. Dispositif selon l'une des revendications 1 à 2, dans lequel un potentiel de test (V_{TEST}) est appliqué à une borne du circuit de test (4) et l'électrode de commande du premier transistor (7a) est connectée à des moyens analogiques d'application d'une tension de modulation.

## Patentansprüche

1. Erfassungsvorrichtung, umfassend:
- einen Photodetektor (1), der mit einem ersten und einem zweiten Anschluss versehen ist,
- eine Leseschaltung (2), die mit einem mit dem ersten Anschluss des Photodetektors (1) verbundenen Eingang versehen ist,
- eine Vorspannungsschaltung (3), die den Anschlüssen des Photodetektors (1) eine Vorspannung auferlegt,
- eine Testschaltung (4), die der Leseschaltung (2) einen Teststrom liefert,
Vorrichtung, **dadurch gekennzeichnet, dass** die Testschaltung (4) einen ersten Transistor (7a) und einen zweiten Transistor (7b) von entgegengesetzten Typen umfasst, die in Reihe geschaltet sind und von dem Teststrom durchflossen werden, wobei der erste Transistor (7a) von der Leseschaltung (2) durch den zweiten Transistor (7b) getrennt ist, der mit einer ersten Hauptelektrode versehen ist, welche mit dem Eingang der Leseschaltung (2) verbunden und derart aufgebaut ist, dass sie eine Verbindungsdiode hat, die dem Durchgang der Ladungsträger entgegenwirkt, wenn das an dem zweiten Anschluss des Photodetektors (1) anliegende Potential an dem ersten Anschluss des Photodetektors (1) anliegt

2. Vorrichtung nach Anspruch 1, wobei die Kathode des Photodetektors (1) an die Leseschaltung (2) angeschlossen ist, der erste Transistor (7a) von nMOS-Typ und der zweite Transistor (7b) vom pMOS-Typ ist oder wobei die Anode des Photodetektors (1) an die Leseschaltung (2) angeschlossen ist, der erste Transistor (7a) von pMOS-Typ und der zweite Transistor (7b) vom nMOS-Typ ist.

3. Vorrichtung nach einem der Ansprüche 1 bis 2, wobei die Testschaltung (4) eine Stromquelle (6) umfasst.

4. Vorrichtung nach einem der Ansprüche 1 bis 2, wobei an einen Anschluss der Testschaltung (4) ein Testpotential (V_{TEST}) angelegt wird und die Steuerelektrode des ersten Transistors (7a) mit analogen Mitteln zum Anlegen einer Modulationsspannung verbunden ist.

## Claims

1. A detection device comprising :
- a photodetector (1) provided with first and second terminals,
- a readout circuit (2) provided with an input connected to the first terminal of the photodetector (1),
- a biasing circuit (3) imposing a bias on the terminals of the photodetector (1),
- a test circuit (4) delivering a test current to the readout circuit (2),
a device **characterized in that** the test circuit (4) comprises a first transistor (7a) and a second transistor (7b) of opposite types connected in series through which the test current flows, the first transistor (7) is separated from the readout circuit (2) by the second transistor (7b) provided with a first main electrode linked to the input of the readout circuit (2) and configured in such a way as to have a junction diode opposing flow of the charge carriers when the potential present on the second terminal of the photodetector (1) is present on the first terminal of the photodetector (1).

2. The device according to claim 1, wherein the cathode of the photodetector (1) is connected to the readout circuit (2), the first transistor (7a) is of nMOS type and the second transistor (7b) is of pMOS type, or wherein the anode of the photodetector (1) is connected to the readout circuit (2), the first transistor (7a) is of pMOS type and the second transistor (7b) is of nMOS type.

3. The device according to one of claims 1 to 2, wherein the test circuit (2) comprises a current source (6).

4. The device according to one of claims 1 to 2, wherein a test voltage (V_{TEST}) is applied to a terminal of the test circuit (4) and the control electrode of the first transistor (7a) is connected to analog means for applying a modulation voltage.
